# EUROPEAN PATENT APPLICATION

(11) **EP 4 776 063 A1**
(43) Date of publication of application: **15.07.2026**
(21) Application number: 25151451.9
(22) Date of filing: 13.01.2025
(51) Int. Cl.: G03F 1/62, B82Y 30/00, G03F 7/00

(54) **PROTECTIVE MEMBRANE FOR AN EXPOSURE APPARATUS AND METHOD**

(71) Applicant: ASML Netherlands B.V., 5500 AH Veldhoven (NL)
(72) Inventor: VAN DE KERKHOF, Marcus Adrianus, 5500 AH Veldhoven (NL); SCHLEGEL, Andreas, 5500 AH Veldhoven (NL); GALUTSCHEK, Ernst, 5500 AH Veldhoven (NL); VAN DE GOOR, Tim Willem Johan, 5500 AH Veldhoven (NL); OSLYAK, Sergiy, 5500 AH Veldhoven (NL)
(74) Representative: ASML Netherlands B.V.

(57) **Abstract**

There is provided a protective membrane (16) for an exposure apparatus (LA) for semiconductor manufacturing processes, the protective membrane (16) comprising boron nitride nanotubes. A component (15) of an exposure apparatus (LA) for semiconductor manufacturing processes comprising such protective membrane (16) is also described. Also provided is an exposure apparatus (LA) for semiconductor manufacturing processes comprising such a protective membrane (16) or component (15). Also described is the use of boron nitride nanotubes as a protective layer in semiconductor manufacturing processes or in an apparatus therefor.

## Description

### FIELD

The present invention relates to a protective membrane for an exposure apparatus for semiconductor manufacturing processes. The present invention also relates to a component of an exposure apparatus for semiconductor manufacturing processes comprising such a protective membrane, as well as to an exposure apparatus for semiconductor manufacturing processes comprising such a protective membrane. The present invention also relates to a method of protecting a component of an exposure apparatus for semiconductor manufacturing processes. The present invention also relates to the use of boron nitride nanotubes as or in a protective layer in semiconductor manufacturing processes or in an apparatus therefor. The present invention also relates to the use of such a protective membrane, component, exposure apparatus or method according to any of the aforesaid in a semiconductor manufacturing process or apparatus therefor. The present invention has particular, but not exclusive application to lithographic apparatuses and methods, metrology apparatuses and methods, inspection apparatuses and methods, such as mask inspection apparatuses and methods, for example actinic mask inspection apparatuses and methods, all of which are or relate to exposure apparatuses or methods for semiconductor manufacturing processes.

### BACKGROUND

Light generated by means of a radiation source can be used by exposure apparatuses for semiconductor manufacturing processes. Examples of such exposure apparatuses are a lithographic apparatus, a metrology, or an inspection apparatus, such as a mask inspection apparatus or an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

A lithographic apparatus includes a patterning device (e.g. a mask or reticle). Radiation is provided through or reflected off the patterning device to form an image on a substrate. A membrane assembly, also referred to as a pellicle, may be provided to protect the patterning device from airborne particles and other forms of contamination. Contamination on the surface of the patterning device can cause manufacturing defects on the substrate.

Pellicles may also be provided for protecting optical components other than patterning devices. Pellicles may also be used to provide a passage for lithographic radiation between regions of the lithography apparatus which are sealed from one another. Pellicles may also be used as filters, such as spectral purity filters or as part of a dynamic gas lock of a lithographic apparatus.

A mask assembly may include the pellicle which protects a patterning device (e.g. a mask) from particle contamination. The pellicle may be supported by a pellicle frame, forming a pellicle assembly. The pellicle may be attached to the frame, for example, by gluing or otherwise attaching a pellicle border region to the frame. The frame may be permanently or releasably attached to a patterning device.

Due to the presence of the pellicle in the optical path of the EUV radiation beam, it is necessary for the pellicle to have high EUV transmissivity. A high EUV transmissivity allows a greater proportion of the incident radiation through the pellicle. In addition, reducing the amount of EUV radiation absorbed by the pellicle may decrease the operating temperature of the pellicle. Since transmissivity is at least partially dependent on the thickness of the pellicle, it is desirable to provide a pellicle which is as thin as possible whilst remaining reliably strong enough to withstand the sometimes hostile environment within a lithography apparatus.

It is therefore desirable to provide a pellicle which is able to withstand the harsh environment of a lithographic apparatus, in particular an EUV lithography apparatus. It is particularly desirable to provide a pellicle which is able to withstand higher powers than previously.

Various other components within an exposure apparatus for semiconductor manufacturing processes require protection from contamination and debris. In addition to potential contaminants and debris, such components may be exposed to high temperatures, illumination by electromagnetic radiation, and to hydrogen plasma. Such conditions can cause degradation in performance or damage to such components and it is therefore desirable to provide protection against at least some of these risks.

The present invention has been devised in an attempt to address at least some of the problems identified above.

### SUMMARY OF THE INVENTION

According to a first aspect of the present disclosure, there is provided a protective membrane for an exposure apparatus for semiconductor manufacturing processes, the protective membrane comprising boron nitride nanotubes.

Membranes comprising carbon nanotubes have been investigated as protective membranes for exposure apparatuses for semiconductor manufacturing processes due, at least in part, to their tolerance of high temperatures which means that they are able to withstand high powers, for example of 1 kW or more. Even so, carbon nanotubes are susceptible to etching when in use due to the presence of hydrogen ions and radicals in hydrogen plasma which comes into contact with the carbon nanotubes. Such etching does not necessarily occur at the same rate across the entire membrane, which can lead to transmissivity non-uniformity, which is undesirable. Etching can also weaken the membranes due to loss of carbon as volatile species. In addition to etching, carbon nanotubes may lose strength due to carbon-carbon bonds being broken and subsequently reforming into a more amorphous structure than the original carbon nanotubes. It has been found that boron nitride can be formed into nanotubes and that such nanotubes are suitable for use in membranes in exposure apparatuses for semiconductor manufacturing processes. It has been found that boron nitride nanotubes are significantly more robust to hydrogen plasma etching than carbon nanotubes. This is unexpected due to the presence of boron and nitrogen which are able to form hydrides which are volatile and would be expected to be etched from the nanotubes in a similar way to how carbon is etched by hydrogen plasma. Boron nitride nanotubes also have a useful level of EUV transmissivity and also show improved etch resistance as compared to carbon nanotubes in an oxygen environment.

The protective membrane may be a freestanding membrane. The protective membrane may be a layer on a component of the exposure apparatus. It is possible to provide a boron nitride nanotube membrane which has sufficient strength to be self supporting. It is also possible to provide a boron nitride nanotube membrane with a support frame to provide additional strength. The boron nitride nanotube membrane does not have to be self supporting and may be provided as a layer on a component. In this way, the boron nitride nanotube membrane functions as a protective layer to provide a barrier between hydrogen plasma and the component which needs to be protected. Additionally, the boron nitride nanotube layer may serve as a heat shield due to its high tolerance of heat loads and low thermal conductivity. The protective membrane can also prevent contaminants from depositing on the component and can also prevent blistering of components, thought to be a result of penetration of hydrogen.

The protective membrane may have an EUV transmissivity of 70% or higher, 75% or higher, 80% or higher, 85% or higher, or 90% or higher. It is possible to control the transmissivity of the protective membrane by controlling the thickness and density of the membrane. Where the protective membrane is intended to be in a path of a beam of radiation, such as EUV radiation, then the transmissivity is preferably greater than 90%. Where the protective membrane is not in the path of a beam of radiation, the EUV transmissivity is less important. Indeed having a lower EUV transmissivity may be advantageous in cases where components may be damaged by exposure to radiation as the protective membrane may reduce the amount of radiation reaching the components which the protective membrane is protecting.

The protective membrane has an operational lifetime of at least 10,000 wafer equivalent exposures (10 kwfrs), at least 20,000, at least 30,000, at least 40,000, at least 50,000, at least 75,000, at least 100,000, at least 250,000, at least 500,000, at least 750,000, or at least 1,000,000 wafer equivalent exposures.

As mentioned, it has been found that boron nitride nanoparticles demonstrate significantly better resistance to hydrogen etching that carbon nanotubes. As such, the lifespan of a protective membrane comprising boron nitride nanotubes anywhere within an exposure apparatus is predicted to be similarly significantly longer than existing membranes.

The boron nitride nanotubes may be functionalised boron nitride nanotubes. The functionalisation may be chemical functionalisation. The functionalisation may be selected to provide specific properties to the boron nitride nanotubes. For example, the chemical affinity of the protective membrane can be adjusted depending on the functionalisation of the nanotubes therein. The hydrophobicity or hydrophilicity of the membrane can similarly be controlled by functionalisation of the nanotubes therein.

The size of pores between boron nitride nanotubes forming the protective membrane may be tuned to a predetermined size. The protective membrane may function as a filter and so by controlling the size of pores in the protective membrane, it is possible to control which materials are and are not able to pass through the protective membrane. The pore size may be from around 1 nm to around 500 nm. The pore size may be from around 10 nm to around 400 nm. The pore size may be from around 20 nm to around 300 nm. The pore size may be from around 30 nm to around 200 nm. The pore size may be from around 40 nm to around 100 nm.

The membrane may be from around 10 nm in thickness to around 100 µm in thickness.

The boron nitride nanotubes may have a boron nitride content of greater than 97wt%, greater than 98wt%, greater than 99wt%, or greater than 99.5wt%.

The boron nitride nanotubes may be single-walled or multiwalled. The boron nitride nanotubes may have from 1 to 5 walls, optionally, the boron nitride nanotubes may have 2 to 3 walls.

The diameter of the boron nitride nanotubes may be from around 1 nm to around 10 nm. The diameter of the boron nitride nanotubes may be from around 1 nm to around 10 nm.

The length of the boron nitride nanotubes from be from around 1 to around 1000 µm. The length may be from around 10 to around 900 µm. The length may be from around 50 to around 700 µm. The length may be from around 100 to around 500 µm. The length may be around 200 µm.

The boron nitride nanotubes may be bundles of nanotubes. The bundles of nanotubes may comprise from 1 to 10 boron nitride nanotubes per bundle. The bundles may comprise from 1 to 5 boron nanotubes per bundle.

The bandgap of the boron nitride nanotubes may be adjusted by doping and/or functionalization. The bandgap of the boron nitride nanotubes may be around 5.5 to 6 eV, for example around 5.7 eV.

According to a second aspect of the present disclosure, there is provided a component of an exposure apparatus for semiconductor manufacturing processes comprising the protective membrane according to the first aspect of the present disclosure.

The component may be a pellicle, a dynamic gas lock, a fiducial, a sensor, an optical element, a sensor, shield, a reticle masking blade assembly component, a filter, a partition, or a flow diverter. The optical element may be a mirror, such as a MEMS (microelectronic mechanical system) mirror. The component may be a pellicle comprising a protective membrane according to the first aspect and a support frame.

Due to the advantageous properties of a protective membrane comprising boron nitride nanotubes, such membranes have multiple uses within an exposure apparatus. For example, as a pellicle, the protective membrane is exposed to radiation, such as EUV radiation, which causes the membrane to heat up to high temperature, such as 500°C or greater, and is also exposed to hydrogen plasma. Since boron nitride nanotubes are resistant to etching by hydrogen plasma and high temperatures, they are eminently suitable for us as pellicle membranes and have displayed operational lifetimes of more than the equivalent of 1 million wafer exposures, which is significantly more than existing pellicle membranes. A longer operational lifespan means that it is possible to reduce the number of times a pellicle is replaced along with the associated throughput impact and defectivity risk. In another example, dynamic gas locks are similar to pellicles in that they are intended to prevent contamination by particles, but to date it has not been possible to provide a membrane in the direct path of the radiation beam due to the intense radiation damaging the membrane. Due to the extreme robustness of a protective membrane comprising boron nitride nanotubes, it is possible to provide a membrane between a source vessel in which radiation, such as EUV radiation is created, and a scanner in which a radiation beam from the source is shaped and used to image a substrate during a semiconductor manufacturing process. In addition, due to the physical strength of a membrane comprising boron nitride nanotubes, it is possible to provide large membranes which can be located away from the intermediate focus to thereby reduce the intensity of radiation illuminating the protective membrane. For example, a protective membrane comprising boron nitride nanotubes can be 100 mm x 100 mm, or can be 300 mm x 300 mm or even larger. Whilst it is appreciated that the presence of any membrane in the path of a radiation beam will incur a penalty, by providing such a membrane, there is a decrease in the transfer of contaminants from the source to the scanner, such as tin particles or tin vapour, which will thereby avoid degradation of the reflectivity of optical elements, such as mirrors, downstream. This may also decrease the requirement for having a pellicle to protect the reticle since tin transfer from the source to the scanner could be eliminated. In another example, where the component is a fiducial, a sensor, or an optical element, the protective membrane may overlie the fiducial to protect the fiducial from hydrogen plasma as well as also protecting it from damage caused by illumination with radiation. Absolute reflectivity of a fiducial is not important, so a low of reflectivity is similarly unimportant. On the other hand, slow degradation of fiducials is an important concern and so providing a protective membrane can serve to slow down any degradation of a fiducial. The protective membrane may also protect the component from deposition of contaminants, such as particles, carbon, or tin.

In another example, the component may be a shield. The shield may protect materials susceptible to damage due to exposure to hydrogen plasma, like titanium embrittlement, from the hydrogen plasma. The shield may be configured to protect another component and may be set apart from the another component such that there is a gap between the shield and the another component. As such, it will be appreciated that the protective membrane does not necessarily have to be in intimate contact with another component in order to provide protection. The component may be a filter. Where the component is a filter, the protective membrane may be configured to allow the passage of certain materials therethrough whilst hindering or blocking the passage of other materials. In this way, the filter may be provided in a gas stream and may serve to remove contaminants, such as particles or vapour or gases, from the gas stream.

In another example, the component may be a partition. A partition serves to divide, wholly or partially, one volume from another. As such, where there is a suspected source of contaminants, a partition may be set up around the suspected source in order to at least partially separate it and thereby contain the contaminants. The partition may be used to determine whether the suspected source of contaminants is actually the source by partitioning it off and measuring whether there is any change in the amount of contaminants observed. In another example, the component may be a flow diverter. Within an exposure apparatus, there is often a flow of gas. The path taken by the gas is important and so the component may be configured to divert or otherwise control the flow of a gas. Since the component comprises boron nitride nanotubes, if the gas is a hydrogen plasma, the nanotubes will not be damaged by the plasma and so the lifespan of the component is higher than would be the case if materials which were not resistant to hydrogen plasma etching, such as carbon nanotubes, were used.

Since the exposure apparatus comprises stainless steel, the protective membrane may be provided with a magnet to allow it to be reversibly attached to the exposure apparatus. The reverse case where the exposure apparatus comprises a magnet and the protective membrane is provided with a suitable material is also contemplated. As such any of the components mentioned herein may include a magnet to allow reversible attachment to a suitable surface.

Accordingly, each of these components may be exposed to hydrogen plasma during nominal operation and it is therefore desirable to provide at least some degree of protection for such components. As mentioned, boron nitride nanotubes are very highly resistant to etching by hydrogen plasma and so providing components with a protective membrane comprising boron nitride nanotubes can protect these components from the hydrogen plasma for extended periods of time. This allows the uptime of any apparatus utilising such components to be increased.

According to a third aspect of the present disclosure, there is provided an exposure apparatus for semiconductor manufacturing processes comprising a protective membrane according to the first aspect or a component according to the second aspect. The exposure apparatus may be a lithographic apparatus, a metrology apparatus, or an inspection apparatus. The lithographic apparatus may be an EUV lithographic apparatus. The inspection apparatus may be a mask inspection apparatus, optionally an actinic mask inspection apparatus.

According to a fourth aspect of the present disclosure, there is provided a method of protecting a component of an exposure apparatus for semiconductor manufacturing processes, the method comprising providing a boron nitride nanotube membrane between the component and a source of contamination or damage.

As mentioned, by providing a boron nitride nanotube protective membrane, it is possible to protect components from etching by hydrogen plasma, from contaminants, and from radiation.

According to a fifth aspect of the present disclosure, there is provided the use of boron nitride nanotubes as a protective layer in semiconductor manufacturing processes or in an apparatus therefor. The boron nitride nanotubes are provided in a membrane or layer.

According to a sixth aspect of the present disclosure, there is provided the use of a protective membrane according to the first aspect, a component according to the second aspect, an exposure apparatus according to the third aspect, a method according to the fourth aspect of the present disclosure in a semiconductor manufacturing process or apparatus therefor.

It will be appreciated that features described in respect of one embodiment may be combined with any features described in respect of another embodiment and all such combinations are expressly considered and disclosed herein.

### BRIEF DESCRIPTION OF THE DRAWINGS

Embodiments of the invention will now be described, by way of example only, with reference to the accompanying schematic drawing in which corresponding reference symbols indicate corresponding parts, and in which:
Figure 1 depicts a lithographic apparatus according to an embodiment of the invention; and
Figure 2 is a schematic depiction of a protective membrane according to the present disclosure supported by a frame.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

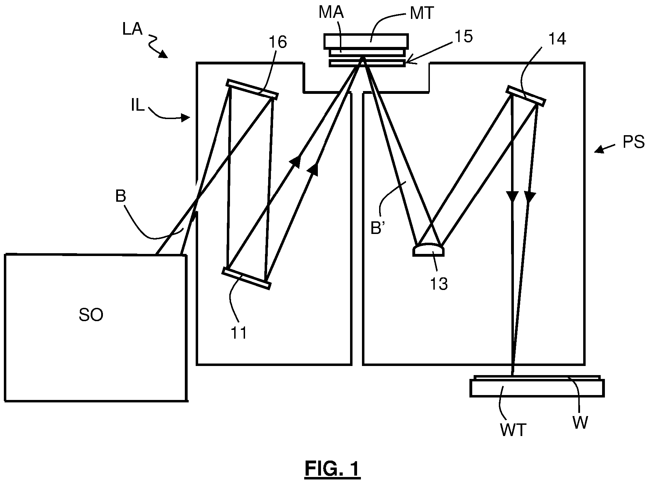

Figure 1 shows an exposure apparatus for semiconductor manufacturing processes, specifically a lithographic system including a pellicle 15 comprising a protective membrane according to one aspect of the present disclosure. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W. In this embodiment, the pellicle 15 is depicted in the path of the radiation and protecting the patterning device MA. It will be appreciated that the pellicle 15 may be located in any required position and may be used to protect any of the mirrors in the lithographic apparatus. The pellicle 15 may be part of a spectral purity filter.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 16 and a facetted pupil mirror device 11. The faceted field mirror device 16 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 16 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

In an embodiment the membrane assembly 15 is a pellicle for the patterning device MA for EUV lithography. The membrane assembly 15 of the present invention can be used for a dynamic gas lock or for a pellicle or for another purpose. In order to ensure maximized EUV transmission and minimized impact on imaging performance it is preferred that the membrane is only supported at the border.

If the patterning device MA is left unprotected, the contamination can require the patterning device MA to be cleaned or discarded. Cleaning the patterning device MA interrupts valuable manufacturing time and discarding the patterning device MA is costly. Replacing the patterning device MA also interrupts valuable manufacturing time.

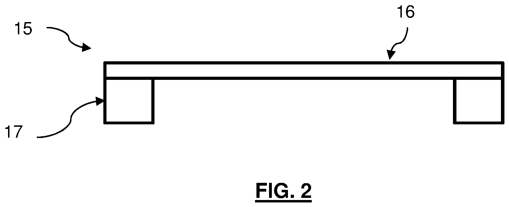

Figure 2 is a schematic depiction of a pellicle 15 accordance to an embodiment of the present disclosure. The pellicle 15 includes a membrane 16 supported by frame 17.

It will be appreciated that other embodiments of the present disclosure may comprise a protective membrane 16 supported by a frame 17. For example, the lifetime and performance of scanner components inside a main vacuum chamber, such as optics, pellicle, or reticle, depend on the surrounding atmosphere. Such components rely on their gas environment for cleaning of unwanted deposits, such as cleaning of deposited carbon by hydrogen plasma, temperature control, such as by convection, as well as particle transport and removal. Control of gas pressures and flows at the location of each component depends on various factors, including inlet pressure, flow rate, pumping speed, geometry as well as the shape, number, and location of the gas inlet and outlet nozzles. Such gas environments are different depending on the type and location of the components in a scanner. For example, hydrogen gas and/or hydrogen plasma is unwanted for structural components of a main chamber due to embrittlement of materials such as titanium. Similarly, optical elements each need a specific local environment due to the different incident radiation intensity at each mirror in order to maximise performance and lifetime. This is a balance between providing sufficient hydrogen to reduce the growth of carbon deposits whilst minimising the risk of hydrogen induced outgassing or blistering. Similarly, pellicles comprising carbon nanotubes, which degrade by etching in hydrogen plasma, may be protected from rapid etching by decreasing the pressure of hydrogen in the reticle mini environment, thereby extending the operational lifetime of such a pellicle. Due to control limitations, it is not possible to optimise the local environment for all components without making trade-offs. As such, the resistance to etching in hydrogen plasma of the protective membranes according to the present disclosure along with their porous structure allows for control of gas flows and pressures across different regions of an exposure apparatus. This allows for tailoring and optimization of the local gas environment of components by protecting such components with the boron nitride nanotube protective membrane, thereby creating a local mini environment, which can be configured to be highly transmissive to EUV radiation. Given the high strength of boron nitride nanotube membranes, the membranes can be used to local control the direction of gas flow, such as for the purpose of thermal control or particle transport.. Hydrogen induced outgassing species originating from within the exposure apparatus can be blocked from reaching sensitive components, such as optics, by using a boron nitride nanotube membrane as a shield.

In addition, in operation, it is no way to control the local gas composition other than to change the flow settings of gas inlets and outlets, and this only achieves limited control over the gas composition at specific components. Boron nitride nanotube membranes according to the present disclosure can selectively filter gas species within the exposure apparatus environment. This can be achieved by one or both of size selectivity, which is dependent on the size of gas molecules and the pore size of the membrane, as well as chemical selectivity. Membrane pore size can be controlled by fabrication technique and chemical affinity can be controlled by functionalisation of the boron nitride nanotubes with functional groups. For example, functionalization can tune the hydrophobicity/hydrophilicity of the boron nitride nanotubes and can therefore be used to control water within an exposure apparatus.

In addition, the protective membranes according to the present disclosure may be used for mitigation or for partitioning to determine or block sources of contamination. Even without a support frame, protective membranes according to the present disclosure may be provided around or over suspected sources of contamination. The protective membranes of the present disclosure are robust, electrically insulating, display near-zero outgassing, and can be made to be very thin.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

In summary, the present disclosure provides for a protective membrane which has excellent resistance to hydrogen plasma as well as excellent strength characteristics. Such membranes are therefore eminently suitable for use in an exposure apparatus which contains hydrogen plasma and also exposes components to high temperatures as well as radiation beams. Boron nitride nanotubes have been found to be orders of magnitude more resistant to hydrogen plasma than carbon nanotubes, meaning that they are expected to have a correspondingly better operational lifespan.

## Claims

1. A protective membrane for an exposure apparatus for semiconductor manufacturing processes, the protective membrane comprising boron nitride nanotubes.

2. The protective membrane according to claim 1, wherein the protective membrane is a freestanding membrane or is a layer on a component of the exposure apparatus.

3. The protective membrane according to claim 1 or claim 2, wherein the protective membrane has an EUV transmissivity of 70% or higher, 75% or higher, 80% or higher, 85% or higher, or 90% or higher.

4. The protective membrane according to any preceding claim, wherein the protective membrane has an operational lifetime of at least 10,000 wafer equivalent exposures (10 kwfrs), at least 20,000, at least 30,000, at least 40,000, at least 50,000, at least 75,000, at least 100,000, at least 250,000, at least 500,000, at least 750,000, or at least 1,000,000 wafer equivalent exposures.

5. The protective membrane according to any preceding claim, wherein the boron nitride nanotubes are functionalised boron nitride nanotubes.

6. The protective membrane according to any preceding claim, wherein the size of pores between the boron nitride nanotubes are tuned to a predetermined size.

7. A component of an exposure apparatus for semiconductor manufacturing processes comprising the protective membrane according to any of claims 1 to 6.

8. The component according to claim 7, wherein the component is a pellicle, a dynamic gas lock, a fiducial, a sensor, an optical element, a shield, a reticle masking blade assembly component, a filter, a partition, or a flow diverter.

9. The component according to claim 7 or 8, wherein the optical element is a mirror, optionally a MEMS mirror.

10. The component according to claim 7 or 8, wherein the component is a pellicle comprising a protective membrane according to any of claims 1 to 6 and a support frame.

11. An exposure apparatus for semiconductor manufacturing processes comprising a protective membrane according to any of claims 1 to 6 or a component according to any of claims 7 to 10.

12. An exposure apparatus according to claim 11, wherein the exposure apparatus is a lithographic apparatus, a metrology apparatus, or an inspection apparatus.

13. An exposure apparatus according to claim 11 or 12, wherein the exposure apparatus is an EUV lithographic apparatus.

14. A method of protecting a component of an exposure apparatus for semiconductor manufacturing processes, the method comprising providing a boron nitride nanotube membrane between the component and a source of contamination or damage.

15. The use of boron nitride nanotubes as a protective layer in semiconductor manufacturing processes or in an apparatus therefor.

16. The use according to claim 15, wherein the boron nitride nanotubes are provided in a membrane or layer.

17. The use of a protective membrane, component, exposure apparatus or method according to any of claims 1 to 14 in a semiconductor manufacturing process or apparatus therefor.
